# FASCICULE DE BREVET EUROPEEN

(11) **EP 1 247 301 B1**
(45) Date de publication et mention de la délivrance du brevet: **26.03.2008**
(21) Numéro de dépôt: 01903936.1
(22) Date de dépôt: 12.01.2001
(51) Int. Cl.: H01L 31/108, H01L 31/101

(54) **Dispositif de photodétection à microrésonateur metalsemiconducteur vertical et procédé de fabrication de ce dispositif**
Photodetektor mit senkrechtem Metall-Halbleiter, Mikroresonator und Herstellungsverfahren
Vertical metal-semiconductor microresonator photodetecting device and production method thereof

(30) Priorité: 14.01.2000 FR 0000468
(43) Date de publication de la demande: 09.10.2002
(73) Titulaire: CENTRE NATIONAL DE LA RECHERCHE SCIENTIFIQUE, 75794 Paris Cedex 16 (FR)
(72) Inventeur: PARDO, Fabrice, F-94400 Vitry-sur-Seine (FR); COLLIN, Stéphane, F-75014 Paris (FR); TEISSIER, Roland, F-34170 Castenau Le Rez (FR); PELOUARD, Jean-Luc, F-75020 Paris (FR)
(74) Mandataire: Breese, Pierre
(86) Numéro de dépôt international: PCT/FR2001/000103
(87) Numéro de publication internationale: WO 2001/052329

(56) Documents cités:
- GB-A- 2 100 511
- US-A- 5 227 648
- US-A- 5 945 720
- CHOU S Y ET AL: "NANOSCALE TERA-HERTZ METAL-SEMICONDUCTOR-METAL PHOTODETECTORS" IEEE JOURNAL OF QUANTUM ELECTRONICS,US,IEEE INC. NEW YORK, vol. 28, no. 10, 1 octobre 1992 (1992-10-01), pages 2358-2368, XP000565156 ISSN: 0018-9197
- PRANK U ET AL: "METAL-SEMICONDUCTOR-METAL PHOTODETECTOR WITH INTEGRATED FABRY-PEROT RESONATOR FOR WAVELENGTH DEMULTIPLEXING HIGH BANDWIDTH RECEIVERS" APPLIED PHYSICS LETTERS,US,AMERICAN INSTITUTE OF PHYSICS. NEW YORK, vol. 62, no. 2, 11 janvier 1993 (1993-01-11), pages 129-130, XP000332226 ISSN: 0003-6951
- DABOO C ET AL: "SURFACE-PLASMON-ENHANCED PHOTODETECTION IN PLANAR AU-GAAS SCHOTTKY JUNCTIONS" THIN SOLID FILMS,CH,ELSEVIER-SEQUOIA S.A. LAUSANNE, vol. 189, no. 1, 1 août 1990 (1990-08-01), pages 27-38, XP000151018 ISSN: 0040-6090
- J. MELENDEZ ET AL: "Development of a surface plasmon resonance sensor for commercial applications" SENSORS AND ACTUATORS B,CH,ELSEVIER SEQUOIA S.A., LAUSANNE, vol. 39, no. 1-3, 1 mars 1997 (1997-03-01), pages 375-379, XP004087775 ISSN: 0925-4005

## Description

### Domaine technique

La présente invention concerne un dispositif de photodétection ainsi qu'un procédé de fabrication de ce dispositif.

Comme on le verra mieux par la suite, le dispositif objet de l'invention présente une grande sélectivité en longueur d'onde, une extrême rapidité et une grande sensibilité.

Il s'applique à tout domaine susceptible de mettre à profit l'une au moins de ces qualités comme, par exemple, la détection spectroscopique de molécules et, plus particulièrement, les télécommunications optiques à très haut débit, supérieur ou égal à 100 Gbits par seconde.

### Etat de la technique antérieure

Les photodétecteurs de type MSM (Métal-Semiconducteur-Métal) sont généralement assez simples à fabriquer, s'intègrent facilement à des circuits à transistors à effet de champ (« field effect transistors ») et permettent d'atteindre des vitesses relativement élevées mais au détriment du rendement. On considère ci-après des photodétecteurs MSM connus et leurs inconvénients.

Dans un photodétecteur connu à base de InGaAs, dont la distance inter-électrodes vaut 1 µm, le temps de transit des trous est de l'ordre de 10 ps, ce qui correspond à une fréquence de coupure de moins de 20 GHz. Il faut donc diminuer la distance inter-électrodes pour diminuer le temps de transit des trous. Lorsque la distance des électrodes tombe en-dessous de 0,1 µm, le transport ne peut plus être considéré comme stationnaire. Le temps de transit devient alors très inférieur à 1 ps.

Le masquage de la zone active par les électrodes est l'un des principaux inconvénients des structures MSM connues et limite leur rendement quantique. De plus, à cause de l'absorption limitée des matériaux utilisés dans ces structures (la longueur d'absorption est supérieure à 1 µm), il faut limiter l'épaisseur de la zone d'absorption pour éviter de créer des porteurs de charge loin des électrodes. L'efficacité quantique des photodétecteurs connus, ayant un intervalle inter-électrodes inférieur à 0,1 µm, est donc extrêmement mauvaise.

Inversement, les structures MSM connues, dont le rendement quantique externe est bon, ont une vitesse faible. Le document S.Y. Chon et al.: "Nanoscale Tera-Hertz Metal-Semiconductor-Metal Photodetectors", IEEE Journal of Quantum Electronics, Vol. 28, No.10, Octobre 1992, pages 2358-2368, décrit un photodétecteur de type MSM en matériau semiconducteur III-V, sans couche électriquement isolante et où les électrodes sont placées au dessus de la surface active.

Mais un photodétecteur ultrarapide (dont le temps de réponse est inférieur à 1 ps) est aujourd'hui un élément crucial pour les télécommunications optiques à très haut débit (100 Gbits/s et au-delà). Les performances recherchées sont une grande sensibilité et une large bande passante, aux longueurs d'onde de 1,3 µm et 1,55 µm. Quel que soit le type de photodétecteur (diode P(I)N ou structure Métal-Semiconducteur-Métal), l'objectif de grande vitesse impose que la distance inter-électrodes soit courte (inférieure à 100 nm) et que la lumière à détecter soit absorbée dans un volume minimal.

Ainsi, le semiconducteur InGaAs massif ("bulk") a une longueur caractéristique d'absorption d'environ 3 µm à la longueur d'onde de 1,55 µm.

Dans les diodes PIN et dans les structures MSM, la diminution du temps de transit des porteurs de charge est directement liée à une diminution du rendement quantique externe.

La conception des photodétecteurs connus fait donc nécessairement l'objet d'un compromis entre rendement et vitesse.

### Exposé de l'invention

Le dispositif objet de l'invention vise à remettre radicalement en cause ce compromis et utilise pour ce faire un micro-résonateur vertical, ce qui permet, par exemple, d'obtenir un rendement quantique au-delà de 70% dans une structure de faible capacité, dont l'intervalle inter-électrodes peut être inférieur à 50 nm et conduire à une bande passante supérieure à 1 THz.

Le principe d'un dispositif conforme à l'invention consiste à concentrer de façon résonnante la lumière que l'on veut détecter, dans une structure de type MSM de faible volume, en utilisant la décroissance rapide d'ondes évanescentes excitées à l'interface Métal/Semiconducteur.

Les modes de plasmons de surface permettent d'atteindre cet objectif. Le document J. Meléndez et al.: "Development of a surface plasmon resonance sensor for commercial applications", Sensors and Actuators B, Vol. 39, Nr. 1-3, 1 Mars 1997, pages 375-379, décrit un photodétecteur qui utilise la résonance des modes de plasmons de surface.

Contrairement aux structures connues, les plasmons ne se propagent pas horizontalement (c'est-à-dire parallèlement au substrat de la structure) mais restent confinés le long de la surface verticale des électrodes de la structure.

De façon précise, la présente invention a pour objet un dispositif de photodétection destiné à détecter une lumière incidente de longueur d'onde prédéfinie, se propageant dans un milieu de propagation, ce dispositif étant caractérisé en ce qu'il comprend une couche électriquement isolante qui n'absorbe pas cette lumière et, sur cette couche, au moins un élément, comprenant un matériau semiconducteur, et au moins deux électrodes de polarisation, destinées à être respectivement portées à des potentiels différents l'un de l'autre, les électrodes encadrant l'élément, l'ensemble formé par l'élément et les électrodes étant apte à absorber la lumière incidente (autrement dit l'élément et/ou les électrodes sont aptes à absorber cette lumière), l'élément et les électrodes ayant une forme sensiblement parallélépipédique et s'étendant suivant une même direction, les dimensions des électrodes et de l'élément, comptées transversalement à cette direction, étant choisies, en fonction de la longueur d'onde prédéfinie, de façon à augmenter l'intensité lumineuse dans l'ensemble formé par l'élément et les électrodes, par rapport à la lumière incidente, en faisant résonner au moins l'un de deux modes, à savoir un premier mode qui est un mode de plasmon de surface et que l'on fait résonner entre les interfaces que présente cet ensemble avec la couche isolante et le milieu de propagation, la résonance de ce premier mode ayant lieu à l'interface entre l'élément et au moins l'une des électrodes, ce premier mode étant excité par la composante du champ magnétique associé à la lumière incidente, composante qui est parallèle aux électrodes, et un deuxième mode qui est un mode transverse électrique d'un guide d'onde optique qui est perpendiculaire à la couche isolante et comprend les deux électrodes, ce deuxième mode. étant excité par la composante du champ électrique associé à la lumière incidente, composante qui est parallèle aux électrodes.

De préférence lorsque l'on fait résonner le mode de plasmon de surface, la largeur de chaque élément, comptée perpendiculairement à la direction des électrodes, est inférieure à λ et supérieure à 0,02xλ où λ est la longueur d'onde de la lumière incidente, et l'épaisseur de chaque élément est inférieure à λ/(2n) où n est l'indice de réfraction moyen de chaque élément.

Selon un premier mode de réalisation particulier du dispositif objet de l'invention, les électrodes sont faites d'un même matériau électriquement conducteur et ont la même hauteur, comptée perpendiculairement à la couche isolante.

Selon un deuxième mode de réalisation particulier, les électrodes ont l'une au moins des deux propriétés (a) d'être faites de matériaux électriquement conducteurs différents et (b) d'avoir des hauteurs différentes, comptées perpendiculairement à la couche isolante, de manière que la résonance ait lieu essentiellement du côté de l'électrode qui recueille les porteurs de charge lents lors de la polarisation des électrodes.

L'élément que comporte le dispositif peut comprendre une hétérostructure semiconductrice.

Selon un mode de réalisation particulier, le dispositif objet de l'invention comprend plusieurs éléments et électrodes qui alternent sur la couche isolante, chaque électrode étant faite d'un seul métal ou de deux métaux différents.

Dans ce cas, dans un premier mode de mise en oeuvre particulier, les électrodes sont destinées à être portées à des potentiels qui vont en croissant d'une électrode d'extrémité à l'autre électrode d'extrémité de l'ensemble des électrodes.

Le dispositif objet de l'invention peut alors comprendre en outre un matériau résistif, stabilisateur de potentiels, qui est en contact avec les électrodes et va d'une électrode d'extrémité à l'autre électrode d'extrémité de l'ensemble des électrodes. Cela permet de polariser sous forte tension l'ensemble des éléments.

Dans un deuxième mode de mise en oeuvre particulier, les électrodes sont destinées à être portées à des potentiels dont les valeurs absolues sont égales et les signes alternent.

Selon un mode de réalisation préféré du dispositif objet de l'invention, ce dispositif comprend en outre un moyen de réflexion compris entre le substrat du dispositif et la couche électriquement isolante prévu pour réfléchir la lumière non absorbée, traversant la couche isolante, l'épaisseur de cette couche isolante étant choisie pour que la lumière réfléchie par le moyen de réflexion soit en phase avec les ondes lumineuses présentes dans l'ensemble formé par chaque élément et les électrodes et participe à la résonance.

Dans un premier exemple, le dispositif objet de l'invention est destiné à détecter une lumière incidente dont la longueur d'onde vaut approximativement 0,8 µm, ce dispositif est formé sur un substrat de GaAs, l'élément est en GaAs., les électrodes en Ag, la couche isolante en AlAs, ou en un matériau AlₓGa₁₋ₓAs, x étant choisi de sorte que ce matériau n'absorbe pas la lumière incidente mais permette une gravure sélective du GaAs, et le moyen de réflexion est un miroir multicouche AlAs/AlGaAs.

Dans un deuxième exemple, le dispositif est destiné à détecter une lumière incidente dont la longueur d'onde vaut approximativement 1,55 µm, ce dispositif est formé sur un substrat en InP, l'élément est en InGaAs, les électrodes en Ag, la couche isolante en AlInAs et le moyen de réflexion est un miroir multicouche GaInAsP/InP ou AlGaInAs/AlInAs. En variante, le dispositif est formé sur un substrat en GaAs, l'élément étant en alliage InGaAsNSb, les électrodes en Ag, la couche isolante en AlAs, ou en un matériau AlₓGa₁₋ₓAs, x étant choisi de sorte que ce matériau n'absorbe pas la lumière incidente mais permette une gravure sélective du GaAs, et le moyen de réflexion étant un miroir multicouche GaAs/AlAs.

Dans un troisième exemple, le dispositif est destiné à détecter une lumière incidente dont la longueur d'onde appartient au domaine infrarouge, et les électrodes sont essentiellement en Ag ou Au pour absorber la lumière incidente, l'élément n'absorbant pas cette lumière incidente.

Selon un premier mode de réalisation particulier de l'invention, le milieu de propagation est l'air.

Selon un deuxième mode de réalisation particulier, le milieu de propagation est un guide de lumière parallèle à la direction suivant laquelle s'étendent les électrodes de chaque élément.

La présente invention concerne aussi un procédé de fabrication du dispositif objet de l'invention, dans lequel on fait croître une épaisseur déterminée du matériau semiconducteur de l'élément sur la couche isolante, on grave sélectivement ce matériau semiconducteur pour en éliminer des portions aux emplacements correspondant aux électrodes et on forme ces électrodes à ces emplacements.

Selon un premier mode de mise en oeuvre particulier du procédé objet de l'invention, on utilise un même masque pour graver sélectivement l'élément puis former les électrodes.

Selon un deuxième mode de mise en oeuvre particulier, on utilise un masque pour graver sélectivement l'élément, on enlève ce masque, on forme les électrodes au moyen d'au moins un métal et l'on enlève l'excédent de ce métal au moyen d'un polissage mécanique ou mécano-chimique.

Dans ce cas, selon un mode de réalisation particulier de l'invention, l'excédent de ce métal est enlevé au moyen d'un polissage mécanique ou mécano-chimique sélectif du métal par rapport à l'élément, cet élément étant composé d'un matériau dont la dureté est grande devant celle du métal.

Selon un autre mode de réalisation particulier, l'élément est composé d'une couche semiconductrice qui absorbe la lumière à détecter sur laquelle a été préalablement déposée une couche diélectrique d'un matériau dont la dureté est grande devant celle du métal et l'excédent de ce métal est enlevé au moyen d'un polissage mécanique ou mécano-chimique sélectif du métal par rapport à l'élément.

Pour former les électrodes, on peut aussi utiliser deux métaux différents que l'on dépose successivement de façon oblique par rapport à la couche isolante.

Il convient de noter que, dans la présente invention, l'utilisation d'un grand nombre d'éléments entre lesquels sont disposées des électrodes, au lieu de l'utilisation d'un seul élément compris entre deux électrodes, permet de construire un réseau dont la modélisation électromagnétique est beaucoup plus simple.

On peut alors montrer que l'on fait résonner le premier mode, qui correspond à des plasmons verticaux, faiblement couplés deux à deux.

Les extrémités inférieures et supérieures des faces verticales des électrodes ont un effet de miroir sur des plasmons d'interface métal-semiconducteur, ce qui permet d'établir une résonance de type Fabry-Pérot et d'absorber ainsi la plus grande partie de l'onde incidente polarisée TM (transverse magnétique).

La modélisation a également permis de mettre en évidence le même phénomène de résonance de type Fabry-Pérot pour les modes TE (transverse électrique) du guide d'onde plan formé entre deux électrodes séparées par un élément et d'absorber ainsi la plus grande partie de la lumière incidente polarisée TE pour des paramètres du dispositif convenablement choisis.

Dans le cas de la polarisation TM comme dans le cas de la polarisation TE, l'absorption totale peut être obtenue en utilisant un miroir de Bragg sous les électrodes pour réfléchir l'onde transmise dans la couche isolante.

Les figures des dessins annexés montrent que, contrairement à l'excitation de plasmons de surface horizontaux (c'est-à-dire parallèles à la couche isolante), la résonance est peu sensible à l'inclinaison de l'onde lumineuse incidente que l'on veut détecter. I1 est donc possible de focaliser fortement cette onde lumineuse sur le dispositif et de ne mettre en oeuvre qu'un petit nombre d'éléments (par exemple 3 à 5), tout en diminuant très peu le rendement quantique du dispositif (par rapport au cas où l'on utilise un grand nombre d'éléments).

De plus, dans le cas de la polarisation TM, il convient de réaliser avec précision l'épaisseur de chaque élément alors que ce n'est pas le cas pour les dimensions transversales de chaque élément et des électrodes.

### Brève description des dessins

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue en perspective schématique et partielle d'un dispositif conforme à l'invention,
- les figures 2 et 3 sont des vues en coupe schématiques et partielles d'autres dispositifs conformes à l'invention,
- la figure 4 montre les variations du taux de réflexion en fonction de l'angle d'incidence de la lumière à détecter, pour deux valeurs différentes de la hauteur du réseau formé par les éléments et les électrodes d'un dispositif conforme à l'invention,
- la figure 5 montre les variations du taux de réflexion en fonction de cette hauteur, dans un dispositif conforme à l'invention,
- les figures 6A à 6E illustrent schématiquement des étapes d'un procédé de fabrication d'un dispositif conforme à l'invention,
- les figures 6F à 6H illustrent schématiquement des variantes de ce procédé, et
- la figure 7 est une vue en perspective schématique d'un autre dispositif conforme à l'invention.

### Exposé détaillé de modes de réalisation particuliers

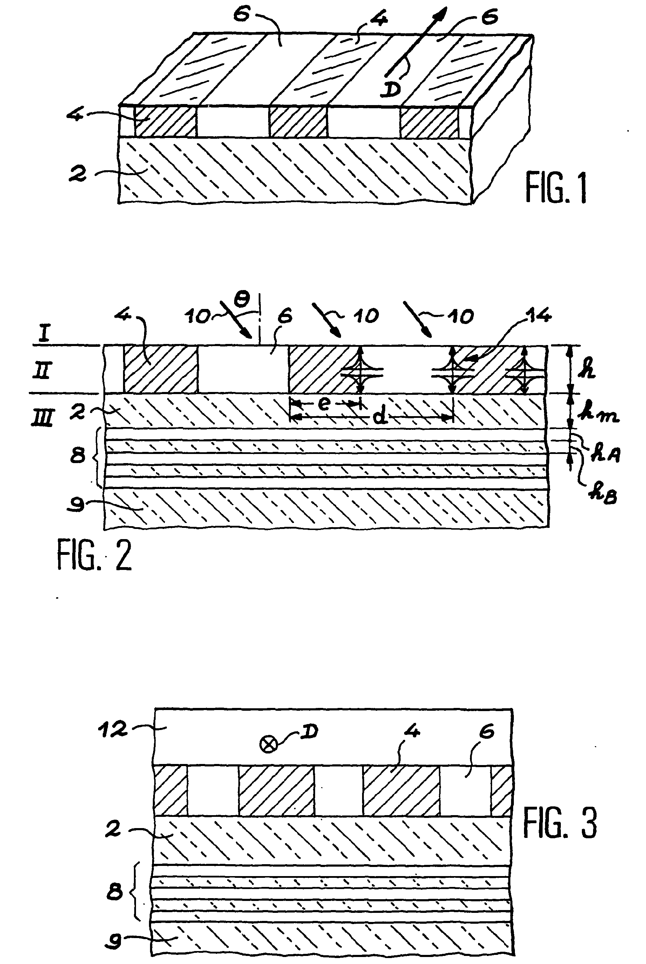

Un dispositif conforme à l'invention est vu en perspective schématique et partielle sur la figure 1. Il s'agit d'une structure formant un réseau de détecteurs métal-semiconducteur-métal, également noté MSM, qui est disposé sur une couche électriquement isolante 2.

Ce réseau est un ensemble d'électrodes métalliques 4 qui alternent avec des éléments semiconducteurs 6.

Ces électrodes et ces éléments ont une forme approximativement parallélépipédique et s'étendent suivant une même direction D sur la couche 2.

Dans l'exemple de la figure 1, il y a plusieurs éléments semiconducteurs. Dans une variante non représentée, on utilise un seul élément semiconducteur 6 compris entre deux électrodes 4.

Un autre dispositif conforme à l'invention est vu en coupe transversale schématique et partielle sur la figure 2. Ce dispositif de la figure 2 est identique à celui de la figure 1 à ceci près qu'il comprend en outre un miroir multicouche 8 également appelé miroir de Bragg.

Ce miroir multicouche est un empilement alterné de couches de matériaux n'absorbant pas la lumière, d'indices de réfraction différents n_{A} et n_{B}. Les épaisseurs respectives h_{A} et h_{B} de ces couches sont calculées en fonction de la gamme de longueurs d'onde à réfléchir.

On voit aussi que le dispositif de la figure 2 est formé sur un substrat 9. Le miroir 8 est compris entre ce substrat et la couche 2.

On peut décomposer le dispositif de la figure 2 (et donc le dispositif de la figure 1) en trois zones I, II et III.

Dans ce qui suit, on suppose que l'onde lumineuse incidente 10 que l'on veut détecter avec le dispositif arrive sur ce dernier par la zone I constituée par de l'air.

On peut décrire de manière similaire le cas d'un dispositif conforme à l'invention placé au contact d'un guide d'onde lumineuse dans lequel se propage une lumière à détecter avec le dispositif. Ce cas est illustré de façon schématique et partielle sur la figure 3 où le guide a la référence 12. Ce guide 12 s'étend suivant la direction D et donc parallèlement aux électrodes 4 et aux éléments semiconducteurs 6.

En revenant à la figure 2, la zone II est composée du réseau des électrodes métallique 4 à section transversale approximativement rectangulaire et des éléments 6 faits d'un semiconducteur qui absorbe la lumière incidente, la longueur d'onde de cette lumière étant connue.

Dans une variante non représentée, chaque élément 6 est composé d'une couche d'un matériau semiconducteur qui absorbe la lumière incidente et d'une couche diélectrique qui recouvre cette couche de matériau semiconducteur.

La zone III correspond à la couche 2 qui est composée d'un semiconducteur non absorbant, en accord de maille avec le semiconducteur de la zone II. Cette zone III peut, comme on l'a vu, inclure un miroir de Bragg qui réfléchit les ondes lumineuses transmises depuis la zone II jusque dans la zone III.

La lumière incidente à détecter 10, que l'on peut décomposer en lumière polarisée TM et en lumière polarisée TE, arrive sur la structure par la zone I. La lumière polarisée TM excite les modes de plasmons de surface le long de l'interface entre le métal et le semiconducteur de la zone II. Les ondes correspondant à ces modes sont alors réfléchies aux interfaces des zones II/III et II/I.

Ce phénomène de résonance pour une polarisation TM est schématisé sur la figure 2 où l'on a symbolisé les plasmons de surface résonants 14.

La hauteur hₘ entre l'interface II/III et le miroir de Bragg 8 est calculée de manière à ce que l'onde transmise de la zone II à la zone III et réfléchie par ce miroir 8 se retrouve en phase avec les ondes (plasmons) dans le milieu II et participe à la résonance.

La lumière polarisée TE excite les modes du guide d'onde plan entre deux électrodes 4. Ces modes se réfléchissent également aux interfaces II/III et II/I et les ondes transmises dans la zone III sont réfléchies par le miroir de Bragg 8.

Le fonctionnement du dispositif est ensuite similaire à celui d'une structure MSM classique :

Des potentiels sont respectivement appliqués aux électrodes (par des moyens de polarisation non représentés) ; ces potentiels peuvent aller en croissant d'une électrode à la suivante (polarisation de manière progressive) ou ces potentiels peuvent être égaux en valeur absolue mais avoir des signes qui alternent en passant d'une électrode à l'autre.

Dans le semiconducteur de la zone II, l'absorption de la lumière se traduit par la création d'une paire électron-trou pour chaque photon absorbé (dont l'énergie est supérieure à la largeur de bande interdite, ou « gap », du semiconducteur). Sous l'effet du champ électrique, l'électron est alors attiré par celle des deux électrodes les plus proches de cet électron, qui a le potentiel le plus élevé et le trou par celle de ces deux électrodes qui a le potentiel le moins élevé. Ce mouvement des charges crée un courant électrique dans les électrodes.

La rapidité de la réponse du photodétecteur dépend des distances entre les électrodes et des potentiels auxquels ces électrodes sont portées.

Notons qu'une partie de l'onde incidente peut être absorbée dans le métal dont sont faites les électrodes. Cette absorption participe partiellement à la création de porteurs dans les éléments semiconducteurs 6 : les électrons excités peuvent passer au-dessus de la barrière de potentiel ou bien passer par effet tunnel.

Les différents matériaux (métal des électrodes, semiconducteurs absorbant et non absorbant) sont choisis en fonction de la longueur d'onde de l'onde incidente à absorber. Par exemple, les électrodes métalliques peuvent être en argent, métal dont le coefficient de réflexion (pour l'Ag massif) est élevé et qui permet donc d'obtenir une forte résonance. L'or, le platine, l'aluminium ou tout autre métal fortement réfléchissant peut être également utilisé. Notons aussi que les électrodes peuvent être constituées de deux métaux, pour des raisons que l'on verra plus loin.

Pour une absorption autour de 0,8 µm, on choisit GaAs comme semiconducteur absorbant et AlAs comme semiconducteur non absorbant (ou, au lieu de AlAs, un matériau AlₓGa₁₋ₓAs, x étant choisi de sorte que ce matériau n'absorbe pas la lumière dont la longueur d'onde est prédéfinie mais permette une gravure sélective du GaAs) et le miroir de Bragg est formé de AlAs et de Al_{0,2}Ga_{0,8}As. Pour une absorption autour de 1,55 µm, on choisit In_{0,53}Ga_{0,47}As comme semiconducteur absorbant et InP comme semiconducteur non absorbant et le miroir de Bragg est formé de GaInAsP/InP ou de AlGaInAs/AlInAs.

D'autre part, les différents paramètres du dispositif e (largeur des électrodes), d (pas du réseau) et h (hauteur du réseau, c'est-à-dire épaisseur des électrodes et des éléments semiconducteurs) ainsi que l'épaisseur hₘ de la couche isolante 2 - voir la figure 2 - sont ajustés de manière à exciter soit les plasmons de surface pour la polarisation TM, soit les modes TE, et de manière à obtenir la résonance de Fabry-Pérot pour ces modes. Il est également possible de choisir ces paramètres de façon à exciter de manière optimale les deux types de modes simultanément.

On précise que, de préférence, la distance d-e entre deux électrodes adjacentes (c'est-à-dire la largeur de chaque élément) est comprise entre λ et 0,02xλ où λ est la longueur d'onde de la lumière à détecter et que h est inférieur à λ/(2n) où n est l'indice de réfraction moyen des éléments 6. On obtient ainsi un dispositif à faible temps de transit et faible capacité.

A titre d'exemple, on peut utiliser un nombre N d'éléments, avec 2≤N≤20, le pas d étant compris entre 0,1xλ et 1xλ.

A λ=0,8 µm et avec les matériaux donnés ci-dessus, on obtient une absorption totale (supérieure à 99%) de l'onde incidente polarisée TM en choisissant un pas du réseau de d=150 nm, un taux de recouvrement (r=e/d) de r=0,5 (50%), une hauteur h du réseau de 55 nm et un miroir de Bragg composé de 20 couches. L'énergie absorbée par le semiconducteur de la zone II est de l'ordre de 74%, le reste (26%) étant absorbé par le métal.

L'onde incidente polarisée TE est également absorbée totalement en choisissant d=150 nm, r=0,4 et h=305 nm. Pour une onde non polarisée, le choix des paramètres d=150 nm, r=0,5 et h=210 nm permet d'obtenir une réflexion de l'onde incidente de 16% et une absorption dans le semiconducteur de l'ordre de 72%.

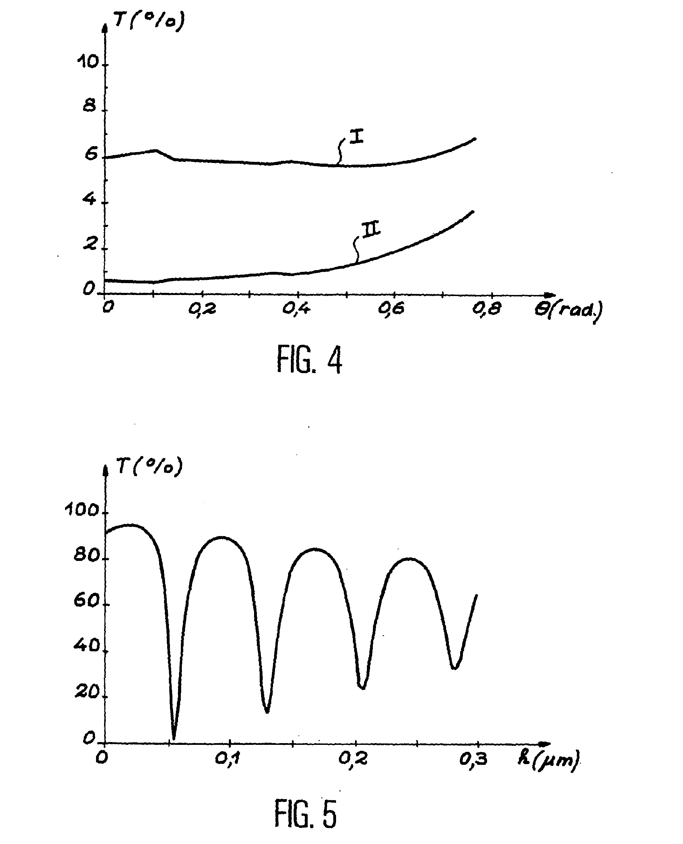

Les courbes des figures 4 et 5 permettent de caractériser les performances de dispositifs conformes à l'invention.

La figure 4 montre les variations du taux de réflexion T (en %), rapport de l'intensité lumineuse réfléchie par le dispositif à l'intensité lumineuse incidente sur ce dispositif, en fonction de l'angle d'incidence θ (en radians) que l'on voit sur la figure 2, pour les valeurs suivantes des paramètres : d=0,15 µm, r=0,5 et h=53 nm pour la courbe I tandis que h=55 nm pour la courbe II.

La figure 5 montre les variations du taux de réflexion T (en %) en fonction de la hauteur h du réseau (en µm) pour d=0,15 µm, r=0,5 et θ=0° (incidence normale).

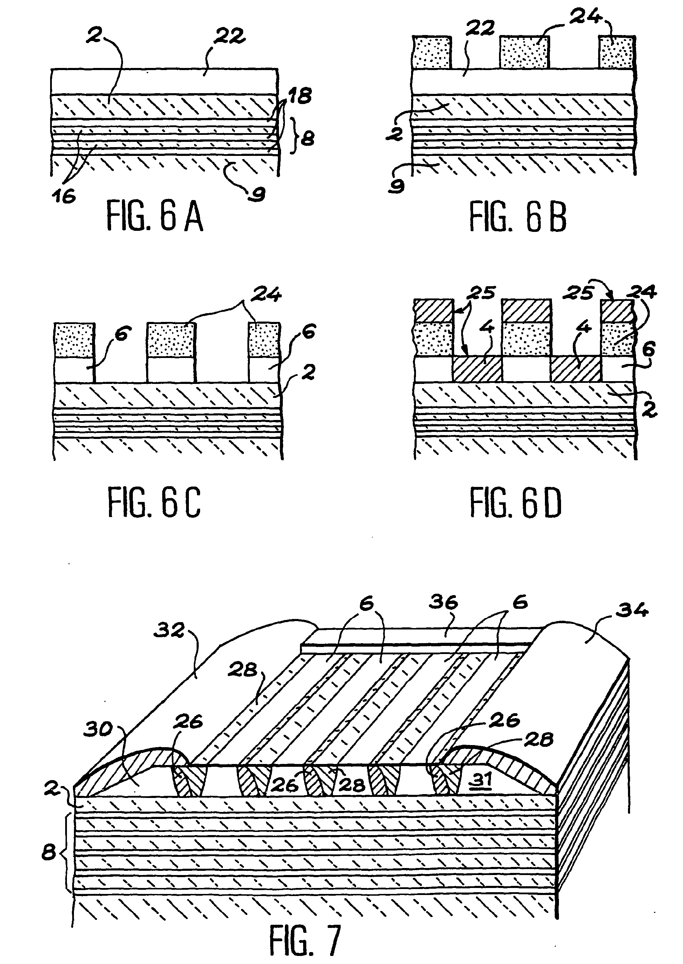

La fabrication d'un dispositif conforme à l'invention, par exemple le dispositif de la figure 2, se fait en cinq étapes qui sont schématisées sur les figures 6A à 6E.

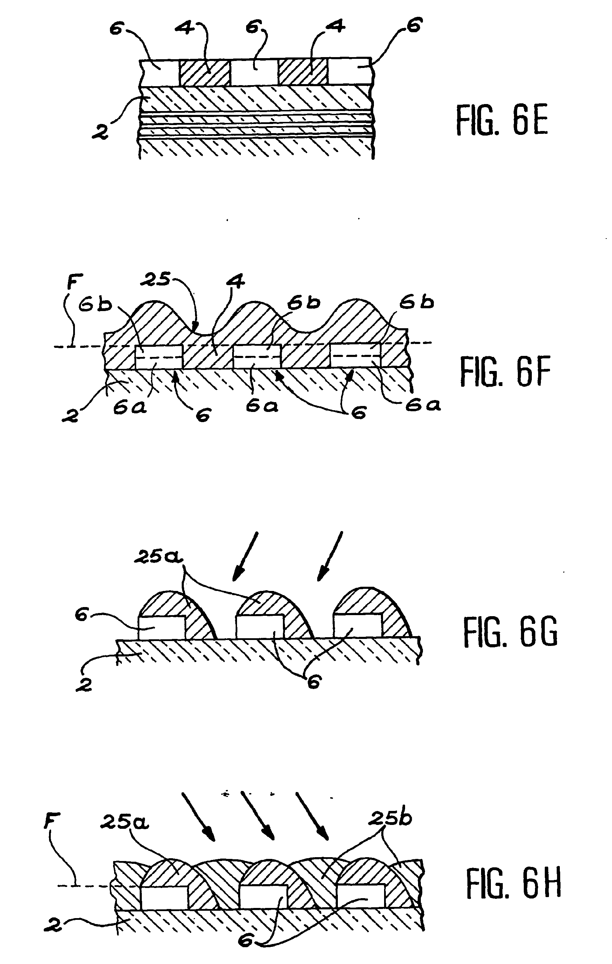

Les couches 16 et 18 du miroir de Bragg, la couche 2 en AlAs et la couche 22 en GaAs qui surmonte la couche 2 (figure 6A) sont réalisées par épitaxie (par exemple par épitaxie par jet moléculaire) sur un substrat 9 de GaAs puis on effectue un masquage électronique des motifs du réseau (figure 6B). On définit ainsi, grâce à des dépôts 24 de masquage (par exemple des dépôts de PMMA), les zones correspondant aux électrodes. On réalise ensuite une gravure ionique réactive de la couche de GaAs (figure 6C). Enfin, on effectue (figure 6D) un dépôt sous vide d'une couche 25 d'argent pour former les électrodes 4 puis un pelage ("lift off") qui conduit à la structure de la figure 6E.

La gravure sélective de la couche de GaAs sur AlAs est obtenue grâce à l'introduction d'oxygène dans le bâti où a lieu la fabrication : lorsque le GaAs est gravé, une fine couche d'oxyde se forme à la surface de la couche de AlAs, diminue considérablement la vitesse de gravure et permet d'arrêter la gravure sur cette couche. Cette sélectivité est généralisable, par exemple pour InGaAs, en introduisant une couche de InAlAs.

La valeur du paramètre h (figure 2), dont le rôle est crucial dans la résonance, est donc maîtrisée au moment de l'épitaxie, à la monocouche près (0,5 nm).

L'étape de métallisation et de lift-off peut être remplacée, après avoir ôté les dépôts 24 (voir figure 6F), par une métallisation et un damasquinage ("damascene") c'est-à-dire un polissage mécanique ou mécanochimique du métal respectant les éléments 6. La flèche F de la figure 6F représente la limite de ce polissage.

Pour faciliter la sélectivité du polissage, chacun des éléments 6 peut être composé d'une couche semiconductrice 6a qui absorbe la lumière à détecter et sur laquelle on a préalablement déposé une couche diélectrique 6b. Cette couche diélectrique 6b peut, par exemple, être en nitrure de silicium Si₃N₄ dont la vitesse de polissage est très lente comparativement à celle de métaux, tels que l'argent, que l'on peut utiliser. La couche diélectrique conduisant à l'ensemble des couches 6b (et servant de couche d'arrêt au polissage grâce à la grande différence de dureté entre le métal et le diélectrique) peut être déposée par pulvérisation (« sputtering ») après avoir fait croître la couche semiconductrice absorbante conduisant à l'ensemble des couches 6a. Ensuite, on dépose un masque, par exemple en nickel, qui sert à protéger les zones correspondant aux éléments 6 au cours des gravures ioniques réactives de la couche diélectrique (gravures fluorées par exemple) puis de la couche semiconductrice absorbante (gravures chlorées par exemple).

Dans le cas où l'on fait la métallisation et le damasquinage, deux métallisations 25a et 25b (voir figures 6G et 6H) avec des sources inclinées par rapport au substrat et mettant en jeu deux métaux différents, permettent de construire des électrodes bimétalliques (cas de la figure 7).

Le dispositif objet de l'invention peut être adapté à une grande plage de longueurs d'ondes, allant du visible à l'infrarouge (plusieurs µm). D'autre part, il peut être réalisé avec une large gamme de matériaux semiconducteurs.

Il est possible d'utiliser différents types de semiconducteurs dans la zone II (figure 2), par exemple sous forme d'hétérostructures (couches épitaxiées) pour améliorer le transport des charges et donc la rapidité du dispositif.

Les calculs ont montré qu'une section des électrodes trapézoïdale ou partiellement arrondie ne changeait pas fondamentalement le fonctionnement du dispositif. En revanche, la hauteur h des éléments joue un rôle important.

L'ajout d'une couche diélectrique dans chaque élément 6 ne modifie pas non plus fondamentalement le fonctionnement du dispositif, mais les hauteurs respectives des différentes couches doivent être redéfinies et jouent un rôle important.

Il est également possible d'utiliser des électrodes dissymétriques afin de favoriser la résonance sur l'électrode la plus négative et de réduire ainsi le trajet des porteurs de charge lents (les trous dans l'exemple considéré) par rapport au trajet des porteurs de charge rapides (les électrons).

Comme on l'a vu, il est possible d'utiliser deux métaux différents pour les électrodes, avec deux objectifs indépendants. L'un est semblable au précédent et vise à favoriser la résonance sur l'électrode la plus négative tandis que l'autre vise à optimiser les hauteurs de barrière pour chacun des deux types de porteurs et donc à réduire le courant d'obscurité.

La création de porteurs dans le métal peut avoir lieu pour des photons d'énergie inférieure à la largeur de bande interdite du semiconducteur des éléments 6 (longueur d'onde plus grande), ce qui élargit le domaine des applications de l'invention.

Un autre dispositif conforme à l'invention est schématiquement représenté en perspective sur la figure 7. On voit encore la couche isolante et le miroir de Bragg 8.

On voit aussi les éléments 6 séparés par des électrodes qui, dans l'exemple considéré, sont chacune en deux parties adjacentes 26 et 28, respectivement faites de deux métaux différents. On voit qu'un élément 6 est alors compris entre une partie 26 et une partie 28 et donc entre deux métaux différents.

Sur la figure 7, les références 30 et 31 représentent des résidus de la couche 22, aux deux extrémités du dispositif.

On voit aussi un contact de cathode 32 et un contact d'anode 34 qui sont respectivement en contact avec les électrodes d'extrémité. Ce contact d'anode et ce contact de cathode sont reliés l'un à l'autre par l'intermédiaire d'un élément résistif 36 qui est en contact avec chaque électrode et permet de stabiliser les potentiels de ces électrodes.

Pour le fonctionnement du dispositif de la figure 7, une tension est appliquée entre les contacts 32 et 34.

## Revendications

1. Dispositif de photodétection destiné à détecter une lumière incidente (10) de longueur d'onde prédéfinie, se propageant dans un milieu de propagation (I, 12), ce dispositif étant **caractérisé en ce qu'**il comprend une couche électriquement isolante (2) qui n'absorbe pas cette lumière et, sur cette couche, au moins un élément (6), comprenant un matériau semiconducteur, et au moins deux électrodes de polarisation (4), destinées à être respectivement portées à des potentiels différents l'un de l'autre, les électrodes (4) encadrant l'élément (6), l'ensemble formé par l'élément (6) et les électrodes (4) étant apte à absorber la lumière incidente, l'élément (6) et les électrodes (4) ayant une forme sensiblement parallélépipédique et s'étendant suivant une même direction (D), les dimensions des électrodes (4) et de l'élément (6), comptées transversalement à cette direction, étant choisies, en fonction de la longueur d'onde prédéfinie, de façon à augmenter l'intensité lumineuse dans l'ensemble formé par l'élément (6) et les électrodes (4), par rapport à la lumière incidente, en faisant résonner au moins l'un de deux modes, à savoir un premier mode qui est un mode de plasmon de surface et que l'on fait résonner entre les interfaces que présente cet ensemble avec la couche isolante (2) et le milieu de propagation (I, 12), la résonance de ce premier mode ayant lieu à l'interface entre l'élément (6) et au moins l'une des électrodes (4), ce premier mode étant excité par la composante du champ magnétique associé à la lumière incidente, composante qui est parallèle aux électrodes (4), et un deuxième mode qui est un mode transverse électrique d'un guide d'onde optique qui est perpendiculaire à la couche isolante (2) et comprend les deux électrodes (4), ce deuxième mode étant excité par la composante du champ électrique associé à la lumière incidente, composante qui est parallèle aux électrodes (4).

2. Dispositif selon la revendication 1, dans lequel on fait résonner le mode de plasmon de surface et dans lequel la largeur (d-e) de chaque élément (6), comptée perpendiculairement à la direction (D), est inférieure à λ et supérieure à 0,02xλ où λ est la longueur d'onde de la lumière incidente, et l'épaisseur (h) de chaque élément est inférieure à λ/(2n) où n est l'indice de réfraction moyen de chaque élément (6).

3. Dispositif selon l'une quelconque des revendications 1 et 2, dans lequel les électrodes (4) sont faites d'un même matériau électriquement conducteur et ont la même hauteur, comptée perpendiculairement à la couche isolante.

4. Dispositif selon l'une quelconque des revendications 1 et 2, dans lequel les électrodes (4) ont l'une au moins des deux propriétés (a) d'être faites de matériaux électriquement conducteurs différents et (b) d'avoir des hauteurs différentes, comptées perpendiculairement à la couche isolante, de manière que la résonance ait lieu essentiellement du côté de l'électrode qui recueille les porteurs de charge lents lors de la polarisation des électrodes (4).

5. Dispositif selon l'une quelconque des revendications 1 à 4, dans lequel l'élément (6) comprend une hétérostructure semiconductrice.

6. Dispositif selon l'une quelconque des revendications 1 à 5, comprenant plusieurs éléments (6) et électrodes (4) qui alternent sur la couche isolante, chaque électrode étant faite d'un seul métal ou de deux métaux différents.

7. Dispositif selon la revendication 6, dans lequel les électrodes (4) sont destinées à être portées à des potentiels qui vont en croissant d'une électrode d'extrémité à l'autre électrode d'extrémité de l'ensemble des électrodes (4).

8. Dispositif selon la revendication 7, comprenant en outre un matériau résistif (36), stabilisateur de potentiels, qui est en contact avec les électrodes (4) et va d'une électrode d'extrémité à l'autre électrode d'extrémité de l'ensemble des électrodes (4).

9. Dispositif selon la revendication 6, dans lequel les électrodes (4) sont destinées à être portées à des potentiels dont les valeurs absolues sont égales et les signes alternent.

10. Dispositif selon l'une quelconque des revendications 1 à 9, comprenant en outre un moyen de réflexion (8) compris entre le substrat (9) du dispositif et la couche électriquement isolante (2) prévu pour réfléchir la lumière non absorbée, traversant la couche isolante (2), l'épaisseur (hₘ) de cette couche isolante (2) étant choisie pour que la lumière réfléchie par le moyen de réflexion (8) soit en phase avec les ondes lumineuses présentes dans l'ensemble formé par chaque élément (6) et les électrodes (4) et participe à la résonance.

11. Dispositif selon la revendication 10, destiné à détecter une lumière incidente dont la longueur d'onde vaut approximativement 0,8 µm, ce dispositif étant formé sur un substrat de GaAs, l'élément (6) étant en GaAs, les électrodes (4) en Ag, la couche isolante (2) en AlAs, ou en un matériau AlₓGa₁₋ₓAs, x étant choisi de sorte que ce matériau n'absorbe pas la lumière incidente' mais permette une gravure sélective du GaAs, et le moyen de réflexion (8) étant un miroir multicouche AlAs/AlGaAs.

12. Dispositif selon la revendication 10, destiné à détecter une lumière incidente dont la longueur d'onde vaut approximativement 1,55 µm, ce dispositif étant formé sur un substrat en InP, l'élément (6) étant en InGaAs, les électrodes (4) en Ag, la couche isolante (2) en AlInAs et le moyen de réflexion (8) étant un miroir multicouche GaInAsP/InP ou AlGaInAs/AlInAs.

13. Dispositif selon la revendication 10, destiné à détecter une lumière incidente dont la longueur d'onde vaut approximativement 1,55 µm, ce dispositif étant formé sur, un substrat en GaAs, l'élément (6) étant en alliage InGaAsNSb, les électrodes (4) en Ag, la couche isolante (2) en AlAs, ou en un matériau AlₓGa₁₋ₓAs, x étant choisi de sorte que ce matériau n'absorbe pas la lumière incidente mais permette une gravure sélective du GaAs, et le moyen de réflexion étant un miroir multicouche GaAs/AlAs.

14. Dispositif selon l'une quelconque des revendications 1 à 10, destiné à détecter une lumière incidente dont la longueur d'onde appartient au domaine infrarouge, dans lequel les électrodes (4) sont essentiellement en Ag ou Au pour absorber la lumière incidente, l'élément (6) n'absorbant pas cette lumière incidente.

15. Dispositif selon l'une quelconque des revendications 1 à 14, dans lequel le milieu de propagation est l'air (I).

16. Dispositif selon l'une quelconque des revendications 1 à 14, dans lequel le milieu de propagation est un guide de lumière (12) parallèle à la direction (D) suivant laquelle s'étendent les électrodes de chaque élément.

17. Procédé de fabrication du dispositif de photodétection selon l'une quelconque des revendications 1 à 16, dans lequel on fait croître une épaisseur déterminée du matériau semiconducteur de l'élément sur la couche isolante (2), on grave sélectivement ce matériau semiconducteur pour en éliminer des portions aux emplacements correspondant aux électrodes (4) et on forme ces électrodes à ces emplacements.

18. Procédé selon la revendication 17, dans lequel on utilise un même masque pour graver sélectivement l'élément puis former les électrodes (4).

19. Procédé selon la revendication 17, dans lequel on utilise un masque pour graver sélectivement l'élément, on enlève ce masque, on forme les électrodes (4) au moyen d'au moins un métal et l'on enlève l'excédent de ce métal au moyen d'un polissage mécanique ou mécano-chimique.

20. Procédé selon la revendication 19, dans lequel l'excédent de ce métal est enlevé au moyen d'un polissage mécanique ou mécano-chimique sélectif du métal par rapport à l'élément, cet élément étant composé d'un matériau dont la dureté est grande devant celle du métal.

21. Procédé selon la revendication 19, dans lequel l'élément est composé d'une couche semiconductrice (6a) qui absorbe la lumière à détecter sur laquelle a été préalablement déposé une couche diélectrique (6b) d'un matériau dont la dureté est grand devant celle du métal et l'excédent de ce métal est enlevé au moyen d'un polissage mécanique ou mécano-chimique sélectif du métal par rapport à l'élément.

22. Procédé selon la revendication 19, dans lequel, pour former les électrodes (4), on utilise deux métaux différents que l'on dépose successivement de façon oblique par rapport à la couche isolante (2).

## Claims

1. A photo-detection device intended for detecting an incident light (10) having a predetermined wavelength, propagating in a propagation medium (I, 12), such device being **characterized in that** it comprises an electrically insulating layer (2) which does not absorb such light, and, on such layer, at least one element (6), comprising a semi-conducting material, and at least two polarization electrodes (4), intended to be respectively brought to potentials different from each other, the electrodes (4) being positioned on either side of the element (6), the assembly formed by the element (6) and the electrodes (4) being capable of absorbing the incident light, the element (6) and the electrodes (4) having a substantially parallelepiped shape and extending in the same direction, and being selected, according to the predetermined wavelength, so as to increase the light intensity in the assembly formed by the element (6) and the electrodes (4), with respect to the incident light, by resonating at least one of two modes, i.e. a first mode which is a surface plasmon mode which is resonated between the interfaces that such assembly has with the insulating layer (2) and the propagation medium (I, 12), the resonance of such first mode occurring at the interface with the element (6) and at least one of the electrodes (4), such first mode being excited by the component of the magnetic field associated with the incident light, a component which is parallel to the electrodes (4), and a second mode which is an electric transverse mode of an optical wave guide, which is perpendicular to the insulating layer (2) and comprises both electrodes (4), such second mode being excited by the component of the electric field associated with the incident light, a component which is parallel to the electrodes (4).

2. A device according to claim 1, wherein the surface plasmon mode is resonated and wherein the width (d-e) of each element (6) computed perpendicularly to the direction (D), is lower than λ and greater than 0.02xλ, where λ is the wavelength of the incident light and the thickness (h) of each element is lower than λ/(2n), where n is the average refraction index of each element (6).

3. A device according to any one of claims 1 and 2, wherein the electrodes (4) are made of the same electrically conducting material and have the same height, computed perpendicularly to the insulating layer.

4. A device according to any one of claims 1 and 2, wherein the electrodes (4) have at least one of two properties (a) being made of different electrically conducting material and (b) having different heights, computed perpendicularly to the insulating layer, such that the resonance substantially occurs on the electrode side which collects the slow charge carriers during the polarisation of the electrodes (4).

5. A device according to any one of claims 1 to 4, wherein the element (6) comprises a semi-conducting heterostructure.

6. A device according to any one of claims 1 to 5, comprising several elements (6) and electrodes (4) which alternate on the insulating layer, each electrode being made of a single metal or of two different metals.

7. A device according to claim 6, wherein the electrodes (4) are intended to be brought to potentials increasing from one end electrode to the other end electrode of the electrodes (4) assembly.

8. A device according to claim 7, further comprising a potential stabilizing resistive material (36), which is in contact with the electrodes (4) and goes from one end electrode to the other end electrode of the electrodes (4) assembly.

9. A device according to claim 6, wherein the electrodes (4) are intended to be brought to potentials, the absolute values of which are equal and the signs alternate.

10. A device according to any one of claims 1 to 9, further comprising a reflection mean (8) comprised between the substrate (9) of the device and the electrically insulating layer (2), provided for reflecting the non-absorbed light, going through the insulating layer (2), the thickness (hₘ) of such insulating layer (2) being selected such that the light reflected by the reflection mean (8) is in phase with the light waves existing in the assembly formed by each element (6) and the electrodes (4) and participates in the resonance.

11. A device according to claim 10, intended to detect an incident light, the wavelength of which is approximately 0.8µm, such device being formed on a substrate made of GaAs, the element (6) being made of GaAs, the electrodes (4) being made of Ag, the insulating layer (2) being made of AlAs or of a AlₓGa₁₋ₓAs material, x being selected such that such material does not absorb the incident light, but allows a selective etching of the GaAs, and the reflection mean (8) being a multilayer AlAs/AlGaAs mirror.

12. A device according to claim 10, intended to detect an incident light, the wavelength of which is approximately 1.55µm, such device being formed on a substrate made of InP, the element (6) being made of InGaAs, the electrodes (4) being made of Ag, the insulating layer (2) being made of AlInAs and the reflection mean (8) being a multilayer GaInAsP/InP or AlGaInAs/AlInAs mirror.

13. A device according to claim 10, intended to detect an incident light, the wavelength of which is approximately 1.55µm, such device being formed on a substrate made of GaAS, the element (6) being made of InGaAsNSb alloy, the electrodes (4) being made of Ag, the insulating layer (2) being made of AlAs, or of a AlₓGa₁₋ₓAs material, x being selected such that such material does not absorb the incident light, but allows a selective etching of the GaAs, and the reflection mean being a multilayer GaAs/AlAs mirror.

14. A device according to any one of claims 1 to 10, intended to detect an incident light, the wavelength of which belongs to the infrared region, wherein the electrodes (4) are mainly made of Ag or Au to absorb the incident light, as the element (6) does not absorb such incident light.

15. A device according to any one of claims 1 to 14, wherein the propagation medium is the air (I).

16. A device according to any one of claims 1 to 14, wherein the propagation medium is a light guide (12) parallel to the direction (D), along which the electrodes of each element extend.

17. A production method of the photo-detection device according to any one of claims 1 to 16, wherein a determined thickness of the semi-conducting material of the element is grown on the insulating layer (2), such semi-conducting material is selectively etched to remove portions therefrom at locations corresponding to the electrodes (4) and such electrodes are formed at such locations.

18. A method according to claim 17, wherein the same resist is used for selectively etching the element and thereafter forming the electrodes.

19. A method according to claim 17, wherein a resist is used for selectively etching the element, the resist is removed, the electrodes (4) are formed using at least one metal and the excess quantity of such metal is removed using a mechanical or mechanical-chemical polishing.

20. A method according to claim 19, wherein the excess of such metal is removed by a selective mechanical or mechanical-chemical polishing of the metal with respect to the element, such element being composed of a material, the hardness of which is high compared to that of the metal.

21. A method according to claim 19, wherein the element is composed of a semi-conducting layer (6a) which absorbs the light to be detected, on which a dielectric layer (6b) of a material the hardness of which is high compared to that of the metal, has previously been deposited.

22. A method according to claim 19, wherein two different metals which are successively deposited in an oblique manner with respect to the insulating layer (2) are used for forming the electrodes (4).

## Patentansprüche

1. Fotodetektionsvorrichtung, die zur Feststellung eines einfallenden Lichts (10) einer vordefinierten Wellenlänge bestimmt ist, das sich in einem Verbreitungsmilieu (I, 12) verbreitet, wobei diese Vorrichtung **dadurch gekennzeichnet, ist, dass** sie eine elektrisch isolierende Schicht (2), die dieses Licht nicht absorbiert, und auf dieser Schicht wenigstens ein Element (6) mit einem Halbleitermaterial und wenigstens zwei Polarisationselektroden (4) umfasst, die jeweils dazu bestimmt sind, auf voneinander unterschiedliche Potenziale zueinander gebracht zu werden, wobei die Elektroden (4) das Element (6) einrahmen, wobei die vom Element (6) und den Elektroden (4) gebildete Struktur geeignet ist, das einfallende Licht zu absorbieren, wobei das Element (6) und die Elektroden (4) eine deutlich parallelflache Form aufweisen und sich gemäß einer und derselben Richtung (D) erstrecken, wobei die Abmessungen der Elektroden (4) und des Elements (6), die transversal zu dieser Richtung gezählt werden, in Abhängigkeit von der vordefinierten Wellenlänge derart ausgewählt werden, dass die Lichtintensität in der vom Element (6) und den Elektroden (4) gebildeten Struktur im Verhältnis zum einfallenden Licht erhöht wird, indem wenigstens einer der zwei Modi in Resonanz gebracht wird, nämlich einem ersten Modus, der ein Oberflächen-Plasmonmodus ist und der zwischen den Schnittstellen in Resonanz gebracht wird, der diese Struktur mit der isolierenden Schicht (2) und dem Verbreitungsmilieu (I, 12) aufweist, wobei die Resonanz dieses ersten Modus an der Schnittstelle zwischen dem Element (6) und wenigstens einem der Elektroden (4) dieses ersten Modus durch die Komponente des dem einfallenden Licht zugeordneten magnetischen Feldes angeregt wird, wobei die Komponente parallel zu den Elektroden (4) ist, und ein zweiter Modus, der ein elektrischer Transversalmodus eines optischen Wellenführers ist, der senkrecht zur isolierenden Schicht (2) verläuft und die zwei Elektroden (4) umfasst, wobei dieser zweite Modus durch die Komponente des dem einfallenden Licht zugeordneten elektrischen Feldes angeregt wird, wobei die Komponente parallel zu den Elektroden (4) verläuft.

2. Vorrichtung gemäß Anspruch 1, in der der Oberflächen-Plasmonmodus in Resonanz gebracht wird und in dem die Breite (d-e) jedes Elements (6), die senkrecht zur Richtung (D) gezählt wird, kleiner ist als λ und größer ist als 0,02 x λ und bei der λ die Wellenlänge des einfallenden Lichts ist und die Dicke (h) jedes Elements geringer ist als λ/ (2n) ist, bei der n der durchschnittliche Refraktionsindex jedes Elements (6) ist.

3. Vorrichtung gemäß Anspruch 1 und 2, in der die Elektroden (4) aus einem und demselben elektrisch leitenden Material hergestellt sind und dieselbe Höhe haben, die senkrecht zur isolierenden Schicht gezählt wird.

4. Vorrichtung gemäß Anspruch 1 und 2, in der die Elektroden (4) wenigstens eine der zwei Eigenschaften (a) haben, aus unterschiedlichen elektrisch leitenden Materialien hergestellt zu sein und (b) unterschiedliche Höhen zu haben, die senkrecht zur isolierenden Schicht derart gezählt werden, dass die Resonanz im Wesentlichen auf der Seite der Elektrode stattfindet, die bei der Polarisation der Elektroden (4) die langsamen Lastenträger aufnimmt.

5. Vorrichtung gemäß Anspruch 1 bis 4, in der das Element (6) eine Halbleiter-Heterostruktur umfasst.

6. Vorrichtung gemäß Anspruch 1 bis 5 mit mehreren Elementen (6) und Elektroden (4), die auf der isolierenden Schicht alternieren, wobei jede Elektrode aus einem einzigen Metall oder aus zwei unterschiedlichen Metallen hergestellt ist.

7. Vorrichtung gemäß Anspruch 6, in der die Elektroden (4) dazu bestimmt sind, auf Potenziale gebracht zu werden, die von einer Endelektrode zur anderen Endelektrode der Struktur der Elektroden größer wird.

8. Vorrichtung gemäß Anspruch 7, die darüber hinaus ein ein Potenzial stabilisierendes, resistives Material (36) umfasst, das mit den Elektroden (4) in Kontakt ist und von einer Endelektrode zur anderen Endelektrode der Struktur der Elektroden (4) verläuft.

9. Vorrichtung gemäß Anspruch 6, in der die Elektroden (4) dazu bestimmt sind, auf Potenziale gebracht zu werden, deren absolute Werte gleich sind und deren Zeichen alternieren.

10. Vorrichtung gemäß Anspruch 1 bis 9, die darüber hinaus ein Reflektionsmittel (8) umfasst, das zwischen dem Substrat (9) der Vorrichtung und der elektrisch isolierenden Schicht (2) inbegriffen ist und das vorgesehen ist, um das nicht absorbierte Licht zu reflektieren, das die isolierende Schicht (2) durchquert, wobei die Dicke (hₘ) dieser isolierenden Schicht (2) ausgewählt ist, damit das vom Reflektionsmittel (8) reflektierte Licht mit den Lichtwellen in einer Phase ist, die in der Struktur vorhanden sind, die durch jedes Element (6) und die Elektroden (4) gebildet wird und zur Resonanz beiträgt.

11. Vorrichtung gemäß Anspruch 10, die zur Feststellung eines einfallenden Lichts bestimmt ist, dessen Wellenlänge rund 0,8 µm wert ist, wobei diese Vorrichtung auf einem GaAs-Substrat gebildet wird, wobei das Element (6) in GaAs ist, die Elektroden (4) aus Ag, die isolierende Schicht (2) aus AlAs oder aus einem Material AlₓGa₁₋ₓAs, wobei x derart ausgewählt wird, dass das Material nicht das einfallende Licht absorbiert, sondern eine selektive Gravur des GaAs erlaubt und das Reflektionsmittel (8) ein vielschichtiger Spiegel AlAs/AlGaAs ist.

12. Vorrichtung gemäß Anspruch 10, die dazu bestimmt ist, ein einfallendes Licht festzustellen, dessen Wellenlänge rund 1,55 µm wert ist, wobei diese Vorrichtung auf einem Substrat aus InP gebildet wird, wobei das Element (6) aus InGaAs ist, die Elektroden (4) aus Ag, die isolierende Schicht (2) aus AlInAs und das Reflektionsmittel (8) ein vielschichtiger Spiegel GaInAsP/InP oder AlGaInAs/A1InAs ist.

13. Vorrichtung gemäß Anspruch 10, die dazu bestimmt ist, ein einfallendes Licht festzustellen, dessen Wellenlänge rund 1,55 µm wert ist, wobei diese Vorrichtung auf einem Substrat aus GaAs gebildet wird, wobei das Element (6) aus einer Legierung InGaAsNSb ist, die Elektroden (4) aus Ag, die isolierende Schicht (2) aus AlAs oder aus einem Material AlₓGa₁₋ₓAs, wobei x derart ausgewählt ist, dass dieses Material das einfallende Licht nicht absorbiert, sondern eine selektive Gravur des GaAs erlaubt und das Reflektionsmittel ein vielschichtiger Spiegel GaAs/AlAs ist.

14. Vorrichtung gemäß Anspruch 1 bis 10, die dazu bestimmt ist, ein einfallendes Licht festzustellen, dessen Wellenlänge zum Infrarotbereich gehört und in der die Elektroden (4) im Wesentlichen aus Ag oder Au sind, um das einfallende Licht zu absorbieren, wobei das Element (6) dieses einfallende Licht nicht absorbiert.

15. Vorrichtung gemäß Anspruch 1 bis 14, in der das Verbreitungsmilieu Luft (I) ist.

16. Vorrichtung gemäß Anspruch 1 bis 14, in der das Verbreitungsmilieu eine zur der Richtung (D) parallele Luftführung (12) ist, in der sich die Elektroden jedes Elements erstrecken.

17. Herstellungsverfahren der Fotodetektionsvorrichtung gemäß Anspruch 1 bis 16, in dem eine bestimmte Dicke des Halbleitermaterials des Elements auf der isolierenden Schicht (2) vergrößert wird, dieses Halbleitermaterial selektiv graviert wird, um daraus Abschnitte aus den Elektroden (4) entsprechenden Stellen zu eliminieren und diese Elektroden an diesen Stellen gebildet werden.

18. Verfahren gemäß Anspruch 17, in dem eine und dieselbe Maske verwendet wird, um das Element selektiv zu gravieren und dann die Elektroden (4) zu bilden.

19. Verfahren gemäß Anspruch 17, in dem eine Maske verwendet wird, um das Element selektiv zu gravieren, diese Maske entfernt wird, die Elektroden (4) mittels wenigstens eines Metalls gebildet werden und der Überschuss dieses Materials mittels eines mechanischen oder mechanisch-chemischen Polierens entfernt wird.

20. Verfahren gemäß Anspruch 19, in dem der Überschuss dieses Materials mittels eines mechanischen oder mechanisch-chemischen selektiven Polierens des Metalls im Verhältnis zum Element entfernt wird, wobei dieses Element aus einem Material gebildet wird, dessen Härte angesichts der des Metalls groß ist.

21. Verfahren gemäß Anspruch 19, in dem das Element aus einer Halbleiterschicht (6a) gebildet wird, die das festzustellende Licht absorbiert und auf der zuvor eine dielektrische Schicht (6b) eines Materials aufgebracht wurde, dessen Härte angesichts der des Metalls groß ist, und der Überschuss dieses Materials mittels eines mechanischen oder mechanisch-chemischen selektiven Polierens des Materials im Verhältnis zum Element entfernt wird.

22. Verfahren gemäß Anspruch 19, in dem zur Bildung der Elektroden (4) zwei unterschiedliche Metalle verwendet werden, die sukzessive schräg im Verhältnis zur isolierenden Schicht (2) aufgebracht werden.
